# DEMANDE DE BREVET EUROPEEN

(11) **EP 0 867 852 A1**
(43) Date de publication de la demande: **30.09.1998**
(21) Numéro de dépôt: 98400679.1
(22) Date de dépôt: 24.03.1998
(51) Int. Cl.: G09F 9/33

(54) **Panneau d'affichage avec diodes montées sur des circuits imprimés**

(30) Priorité: 28.03.1997 FR 9703831
(71) Demandeur: Sécurité et Signalisation, 37310 Chambourg-sur-Indre (FR)
(72) Inventeur: Gauthier, Franck, 37390 Metteray (FR); Passet, Pierre, 37540 St Cyr-Sur-Loire (FR); Migny, Philippe, 37540 St Cyr-Sur-Loire (FR)
(74) Mandataire: Le Bras, Hervé

(57) **Abrégé**

L'invention concerne un panneau d'affichage (20) au moyen de diodes (4) disposées en matrice sur des circuits imprimés (1) devant une surface d'affichage constituée d'une tôle multiperforée (21).

Les circuits imprimés (1) sont disposés dans un plan vertical (23) et les diodes (4) ont des axes (5) sensiblement parallèles, dirigés vers le bas et faisant un angle (α) avec la normale (11) au plan (23).

## Description

L'invention concerne le domaine de l'affichage de messages au moyen d'éléments émetteurs de lumière disposés en matrice sur une surface d'affichage d'un panneau.

Elle concerne plus précisément un panneau utilisé pour l'affichage de caractères alphanumériques ou d'éléments graphiques, en extérieur, sur les réseaux routiers ou autoroutes par exemple, du type comportant une surface d'affichage sensiblement verticale constituée par une tôle multiperforée et une pluralité de circuits imprimés disposés côte à côte et bout à bout derrière ladite tôle, chaque circuit imprimé comportant sur sa face en regard de la tôle une pluralité d'éléments émetteurs de lumière arrangés en matrice derrière les ouvertures de ladite tôle, chaque élément émetteur comportant lui-même une pluralité de diodes électroluminescentes disposées côte à côte et retenues sur le circuit imprimé correspondant par leurs électrodes.

Dans les panneaux d'affichage actuels, les diodes électroluminescentes sont montées perpendiculairement sur leurs supports. Les circuits imprimés ainsi que les tôles multiperforées sont disposés avec une légère inclinaison par rapport à la verticale afin de permettre à l'usager de la voie routière de voir le message affiché lorsqu'il se trouve au delà d'une zone proche du panneau d'affichage, ce dernier étant installé au-dessus de la voie de circulation. D'autre part, pour permettre l'accès à l'intérieur du panneau au personnel chargé de la maintenance et de la réparation, il est d'usage de monter les circuits imprimés et les tôles multiperforées sur des châssis pouvant pivoter autour d'axes latéraux, de préférence verticaux.

L'inclinaison donnée aux circuits imprimés et aux tôles et le souhait d'avoir des axes de pivotement verticaux entraînent des complications dans la réalisation des panneaux d'affichage.

Le but de la présente invention est de proposer un panneau d'affichage du type mentionné ci-dessus qui présente une surface d'affichage verticale, tout en assurant une lisibilité parfaite pour les utilisateurs.

L'invention atteint son but par le fait que les circuits imprimés sont tous disposés dans un même plan sensiblement vertical et par le fait que les diodes ont des axes sensiblement parallèles entre eux et faisant un angle aigu avec la normale audit plan.

De manière avantageuse, les axes des diodes sont inclinés vers le bas à partir dudit plan. Cet angle est avantageusement compris entre 1 et 5°.

De préférence, les deux électrodes d'une diode sont disposées dans un plan vertical.

Grâce à cette disposition, les électrodes éclairent dans un lobe ayant un axe incliné vers le bas et dirigé vers la voie routière.

Selon une autre caractéristique de l'invention, les ouvertures de la tôle multiperforée ont sensiblement la forme d'un triangle isocèle avec un sommet en haut.

Cette disposition élimine en grande partie les reflets provoqués par la lumière solaire rasante sur des diodes.

L'invention concerne également un circuit imprimé pour panneau d'affichage qui comporte sur une face une pluralité d'éléments émetteurs de lumière arrangés en matrice, chaque élément émetteur comportant lui-même une pluralité de diodes électroluminescentes disposées côte à côte et retenues sur ledit circuit imprimé par leurs électrodes.

Ce circuit imprimé est caractérisé par le fait que les diodes ont des axes sensiblement parallèles entre eux et faisant un angle aigu avec la perpendiculaire à ladite face de circuit imprimé.

Avantageusement, les deux électrodes d'une diode sont disposées sensiblement dans un plan perpendiculaire à ladite face et contenant l'axe de ladite diode.

L'angle est compris de préférence entre 1 et 5°.

D'autres avantages et caractéristiques de l'invention ressortiront à la lecture de la description suivante faite à titre d'exemple et en référence au dessin annexé dans lequel :
la figure 1 est une vue de face d'un circuit imprimé selon l'invention utilisé dans un panneau d'affichage et comportant sur sa face avant des diodes électroluminescentes ;
la figure 2 est une coupe selon la ligne II-II de la figure 1 ;
la figure 3 est une coupe schématique d'un panneau d'affichage selon la présente invention, prise selon un plan vertical ;
la figure 4 est une vue de l'avant du panneau d'affichage de la figure 3 ;
la figure 5 montre une pastille d'obturation d'une ouverture ;
la figure 6 est une coupe selon la ligne VI-VI de la figure 4 de la tôle multiperforée.

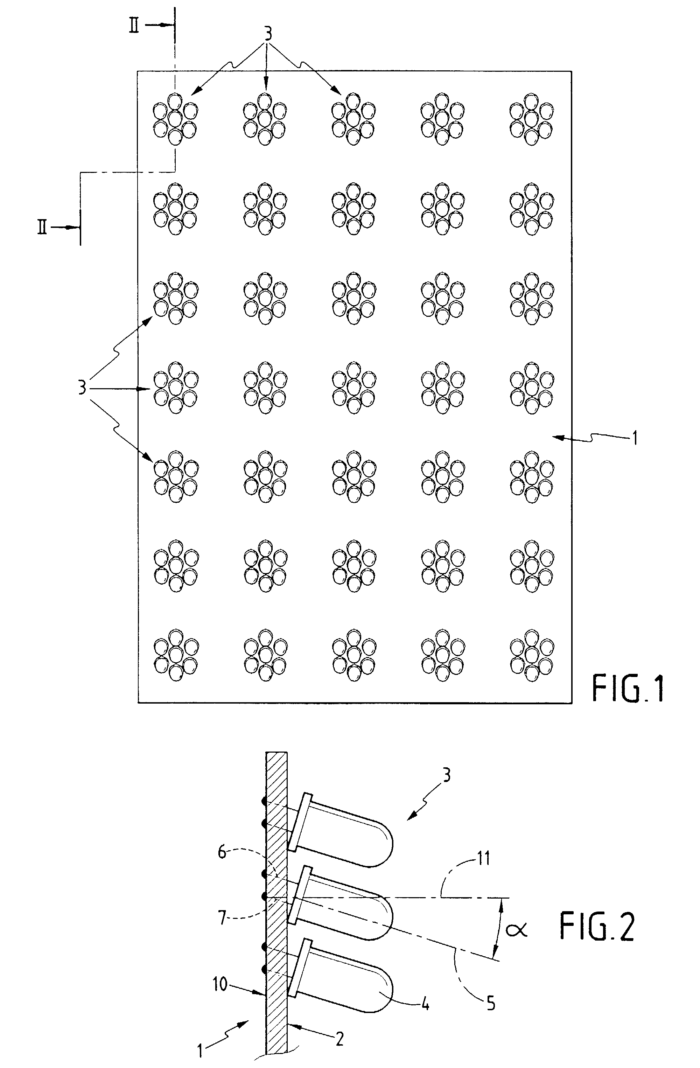

Les figures 1 et 2 montrent un circuit imprimé 1 de forme rectangulaire qui présente sur sa face avant 2 une pluralité d'éléments émetteurs de lumière 3 disposés en matrice et constitués chacun d'une pluralité de diodes électroluminescentes 4. Chaque diode 4, d'axe 5, présente sur une face d'extrémité deux électrodes 6 et 7 qui traversent le corps du circuit imprimé 1 et qui sont fixés par soudure aux circuits d'alimentation électriques prévus sur l'autre face 10 du circuit imprimé 1.

Selon la présente invention les axes 5 des diodes 4 sont sensiblement parallèles entre eux et forment un angle aigu α avec la perpendiculaire 11 au circuit imprimé 1. Les deux électrodes 6 et 7 de chaque diode 4 sont disposés dans un plan perpendiculaire au circuit imprimé 1 et contenant l'axe 5 de ladite diode 4.

Ainsi qu'on le voit sur la figure 2, les deux électrodes 6 et 7 ont ainsi des longueurs légèrement différentes. Les soudures des électrodes 6 et 7 sont réalisées de manière connue par le procédé dit soudure à la vague.

Grâce à cette structure, les diodes 4 du circuit imprimé 1 émettent la lumière dans une direction privilégiée parallèle à l'axe 5.

L'angle α a une valeur comprise entre 1 et 5°, et de préférence cette valeur est de 3° ou 4°.

Les circuits imprimés 1 décrits plus haut sont destinés à être montés côté à côte et bout à bout dans un châssis d'un panneau d'affichage 20, utilisé pour la signalisation au-dessus d'une voie routière, derrière une tôle plane opaque 21 qui présente des ouvertures 22 devant les éléments émetteurs de lumière 3.

Les circuits imprimés 1 sont disposés dans un plan vertical 23 parallèle à la tôle 21, et de telle manière que les axes 5 des diodes 4 sont sensiblement parallèles entre eux et dirigés vers le bas en partant du plan vertical 23.

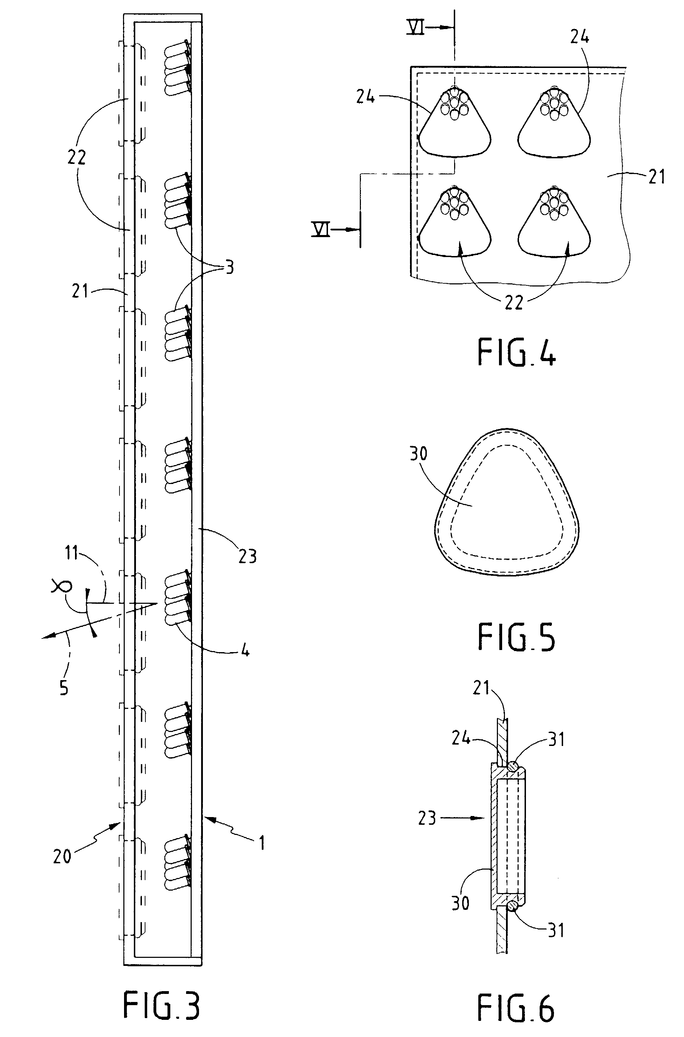

Ainsi qu'on le voit sur la figure 4, les ouvertures 23 ont la forme d'un triangle isocèle ou équilatéral, avec des sommets arrondis, l'un des sommets 24 étant disposé dans la partie supérieure de l'ouverture 23.

Les ouvertures 23 sont obturées par des pastilles 30 en matériau transparent qui comportent un manchon 31 de section tiangulaire conjuguée à la forme des ouvertures 23. La fixation d'une coupelle sur la tôle 21 est réalisée par un anneau élastique 32 qui loge en partie dans une rainure prévue à la périphérie du manchon 31. Cet anneau assure également l'étanchéité à l'eau de pluie.

## Revendications

1. Circuit imprimé pour panneau d'affichage comportant sur une face (2) une pluralité d'éléments émetteurs (3) de lumière arrangés en matrice, chaque élément émetteur (3) comportant lui-même une pluralité de diodes (4) électroluminescentes disposées côte à côte et retenues sur ledit circuit imprimé (1) par leurs électrodes (6, 7),
caractérisé par le fait que les diodes (4) ont des axes (5) sensiblement parallèles entre eux et faisant un angle aigu (α) avec la perpendiculaire à ladite face (2) de circuit imprimé.

2. Circuit imprimé selon la revendication 1, caractérisé par le fait que les deux électrodes (6, 7) d'une diode sont disposées sensiblement dans un plan perpendiculaire à ladite face (2) et contenant l'axe (5) de ladite diode (4).

3. Circuit imprimé selon l'une quelconque des revendications 1 ou 2, caractérisé par le fait que l'angle (α) est compris entre 1° et 5°.

4. Panneau d'affichage comportant une surface d'affichage sensiblement verticale constituée par une tôle multiperforée (21), et une pluralité de circuits imprimés (1) disposés côte à côte et bout à bout derrière ladite tôle (21), chaque circuit imprimé comportant sur sa face (2) en regard de ladite tôle (21) une pluralité d'éléments émetteurs (3) de lumière arrangés en matrice derrière les ouvertures (22) de ladite tôle (21), chaque éléments émetteur (3) comportant lui-même une pluralité de diodes (4) électroluminescentes disposées côte à côte et retenues sur ledit circuit imprimé (1) correspondant par leurs électrodes (6, 7),
caractérisé par le fait que les circuits imprimés (1) sont tous disposés dans un même plan (23) sensiblement vertical et par le fait que les diodes (4) ont des axes (5) sensiblement parallèles entre eux et faisant un angle aigu (α) avec la normale (11) audit plan (23).

5. Panneau d'affichage selon la revendication 4, caractérisé par le fait que les axes (5) des diodes (4) sont inclinés vers le bas à partir dudit plan (23).

6. Panneau d'affichage selon la revendication 5, caractérisé par le fait que les deux électrodes (6, 7) d'une diode (4) sont disposées dans un plan vertical.

7. Panneau d'affichage selon l'une quelconque des revendications 4 à 7, caractérisé par le fait que l'angle (a) est compris entre 1° et 5°.

8. Panneau d'affichage selon l'une quelconque des revendications 4 à 7, caractérisé par le fait que les ouvertures (22) de la tôle multiperforée (21) ont sensiblement la forme d'un triangle avec un sommet, disposé en haut, et sont obturées par des pastilles (30) en matériau transparent.
